# FASCICULE DE BREVET EUROPEEN

(11) **EP 1 791 170 B1**
(45) Date de publication et mention de la délivrance du brevet: **01.04.2009**
(21) Numéro de dépôt: 07100845.2
(22) Date de dépôt: 26.11.2001
(51) Int. Cl.: H01L 21/20, C30B 25/18

(54) **Procédé de fabrication d'un substrat notamment pour l'optique, l'électronique ou l'optoélectronique et substrat obtenu par ce procédé**
Verfahren zur Herstellung eines Substrats, insbesondere für optische, elektronische oder optoelektronische Anwendungen, und mittels dieses Verfahrens erhaltenes Substrat
Method of manufacturing a substrate, in particular for optics, electronics or optoelectronics, and substrate obtained through said method

(30) Priorité: 27.11.2000 FR 0015279
(43) Date de publication de la demande: 30.05.2007
(62) Demande divisionnaire de: 01997835.2
(73) Titulaire: S.O.I.Tec Silicon on Insulator Technologies, 38190 Bernin (FR)
(72) Inventeur: Letertre, Fabrice, 38000, Grenoble (FR); Ghyselen, Bruno, 38170, Seyssinet-Pariset (FR)
(74) Mandataire: Bomer, Françoise Marie

(56) Documents cités:
- WO-A-00/44966
- FR-A- 2 767 416
- FR-A- 2 774 214
- FR-A- 2 787 919
- HOBART K D ET AL: "Transfer of ultrathin silicon layers to polycrystalline SiC substrates for the growth of 3C-SiC epitaxial films" JOURNAL OF THE ELECTROCHEMICAL SOCIETY, vol. 146, no. 10, octobre 1999 (1999-10), pages 3833-3836, XP002174444 ISSN: 0013-4651

## Description

L'invention concerne le domaine des procédés de fabrication de substrats, notamment pour l'optique, l'électronique ou l'optoélectronique, ainsi que celui des substrats obtenus par de tels procédés. Plus particulièrement, il peut s'agir de substrats pouvant être utilisés pour la fabrication de diodes électroluminescentes et laser.

On souhaite souvent, pour une utilisation en optique, en électronique ou en opto-électronique, obtenir des substrats comportant une couche utile mince. On connaît dans ce cas deux grandes familles de procédés pour réaliser de tels substrats. Ce sont les procédés dans lesquels on transfère une couche mince prélevée sur un substrat source, pour la reporter sur un substrat support, et les procédés dans lesquels on dépose la couche mince, sur un substrat support, par une technique de dépôt telle que l'épitaxie par jet moléculaire (aussi connue de l'homme du métier sous l'acronyme MBE de l'expression anglo-saxonne « Molecular Beam Epitaxy »), le dépôt chimique en phase vapeur d'organométalliques (aussi connue de l'homme du métier sous l'acronyme MOCVD de l'expression anglo-saxonne « Metal Organic Chemical Vapor Deposition »), etc. Cependant, il existe des matériaux dont on ne dispose pas, ou très difficilement, sous forme d'un substrat source à partir duquel on peut prélever une couche mince, et/ou dont la croissance par dépôt sur un substrat support n'est pas encore satisfaisante. C'est le cas notamment du nitrure de gallium monocristallin, qui n'existe pas sous forme monocristalline massive dans une qualité et/ou des diamètres satisfaisants et/ou un prix raisonnable et que l'on ne peut donc faire croître que par une technique d'hétéroépitaxie.

Par ailleurs, dans toutes les techniques connues de croissance d'une couche utile sur une couche germe elle-même portée par un support, on recherche souvent à éliminer le support en question pour obtenir le produit final.

Différentes techniques sont connues pour ce faire. Ainsi le document FR 2 787 919 A décrit l'élimination d'un tel substrat par une technique d'amincissement mécano-chimique. Mais toutes les techniques d'élimination du support par attaque ou technique équivalente sont indésirables car elles mènent à des pertes significatives d'une matière qui parfois s'avère coûteuse.

Le document US 6 114 188 A décrit quant à lui une technique de séparation d'un film d'oxyde complexe de métal de transition (CTMO) réalisé par dépôt en effectuant un traitement spécial sur le substrat natif à partir duquel la croissance du film sera effectuée, puis en effectuant un détachement entre le film déposé et ce substrat natif. Cette technique est toutefois indésirable car elle risque de compromettre le bon démarrage de la croissance du film et amener soit des pertes de rendement, soit à une moindre qualité de la couche déposée.

La présente invention vise à pallier ces inconvénients.

Elle propose à cette effet un procédé de fabrication de substrats, notamment pour l'optique, l'électronique ou l'opto-électronique, comprenant les étapes suivantes :
- report d'une couche germe sur un support par adhésion moléculaire au niveau d'une interface de collage,
- épitaxie d'une couche utile sur la couche germe.

Conformement à l'invention, ce procédé comprend également les étapes suivantes:
- collage direct d'un substrat raidisseur sur ladite couche utile (16),
- retrait du support (12),
ledit support (12) étant constitué d'un matériau dont le coefficient de dilatation thermique est 0,7 à 3 fois celui de la couche utile (16), et la couche germe (2) étant apte à s'adapter aux dilatations thermiques du support (12) et de la couche utile (16).

Par ailleurs, et pour revenir au nitrure de gallium, il est connu que le saphir et le carbure de silicium peuvent constituer, pour ce matériau, de bons substrats germes pour une hétéroépitaxie. Mais le saphir est un isolant électrique, ce qui présente un inconvénient pour certaines applications, et le carbure de silicium monocristallin présente les inconvénients d'être cher et peu disponible en grand diamètre. Pour le nitrure de gallium, un substrat idéal pour une hétéroépitaxie serait le silicium {111}. On considère que c'est un substrat idéal car son utilisation est très répandue (donc ne perturberait pas de nombreuses chaînes de traitement de substrats dans lesquelles ce matériau est déjà utilisé), il est peu onéreux et il est disponible dans de grands diamètres. Mais les tentatives faites pour déposer du nitrure de gallium sur du silicium {111}, utilisant la technique standard de dépôt par MOCVD à 1000°C-1100°C environ, se sont heurtées à un problème de formation de dislocations, dont la concentration dans la couche mince de nitrure de gallium est supérieure à 10⁸/cm², voire de fissuration de cette couche mince.

Un autre but de l'invention est de fournir un procédé permettant d'obtenir des couches minces utiles de meilleure qualité que celles obtenues par les procédés de l'art antérieur, notamment pour les matériaux dont on ne dispose pas, ou très difficilement, sous forme d'un substrat source à partir duquel on peut prélever une couche mince, ou dont la croissance par dépôt sur un substrat support n'est pas encore satisfaisante. La qualité des couches minces utiles en question s'analysant en particulier et en premier lieu en terme de fissures et secondairement en terme de concentration de dislocations.

Préférentiellement, les valeurs des coefficients de dilatation thermique considérés dans ce document concernent ceux d'un plan parallèle à celui de la couche utile.

Grâce à cette particularité, le matériau choisi pour former le support présente des coefficients de dilatation thermique tels que l'on réduit, voire on élimine, les contraintes importantes en tension ou en compression, intervenant au cours des variations de température inhérentes à la croissance de la couche utile, ou au cours du retour du substrat ainsi formé, à la température ambiante.

On remarquera, notamment en relation avec les problèmes de fissuration, que la tolérance vis à vis des différences entre les coefficients de dilatation thermique des matériaux respectifs de la couche utile et du support est plus grande lorsque cette différence engendre une compression de la couche utile que lorsqu'elle engendre un étirement de cette dernière. Ainsi, en compression, le coefficient de dilatation thermique du matériau du support peut être plusieurs fois plus grand que celui de la couche utile. Tandis qu'en extension, le coefficient de dilatation thermique du matériau du support sera préférentiellement au moins égal à 0,7 fois celui de la couche utile.

On notera que la couche germe est apte à s'adapter aux dilatations thermiques imposées par le support et/ou la couche utile. Pour ce faire, la couche germe est d'une épaisseur suffisamment faible pour être déformable et suivre les variations dimensionnelles dues à la dilatation thermique du support et/ou de la couche utile. Cette épaisseur dépend du matériau constitutif de la couche germe et de ceux respectifs du support et de la couche utile. Typiquement pour un support de carbure de silicium de 300 microns d'épaisseur et une couche utile de nitrure de gallium de plusieurs microns d'épaisseur, une couche germe de carbure de silicium monocristallin est inférieure à 0,5 micron d'épaisseur et est de préférence inférieure à 100 nm (1000 Å).

Avantageusement, le matériau constitutif de la couche germe présente également des paramètres de maille tels qu'on réalise une épitaxie de la couche utile sur la couche germe avec une concentration de dislocations dans la couche utile inférieure à 10⁷/cm². Il est connu de l'homme du métier comment réaliser une telle épitaxie en choisissant les paramètres et les orientations respectives des couches germe et utile.

A titre d'exemple, le tableau 1 ci-dessous regroupe les paramètres de mailles et les coefficients de dilatations thermiques de plusieurs matériaux susceptibles d'être utilisés pour la mise en oeuvre du procédé selon l'invention, en tant que matériau pour la couche utile ou en tant que matériau pour la couche germe ou le substrat support.

**Tableau 1**

| | GaN (W) | AIN (W) | Al₂O₃ (H) | Si (C) | 6H-SiC(W) |
|---|---|---|---|---|---|
| Paramètres de maille (Å) (1Å=0,1nm) | a = 3,189 | a = 3,112 | a = 4,758 | c = 5,430 | a = 3,08 |
| | c = 5,185 | c = 4,982 | c = 12,99 | | c = 15,12 |
| Coefficients de dilatation thermique selon a ou c (x10⁻⁶K⁻¹) | 5,59 | 4,15 | 7,5 | 2,6 | 4,20 |
| | 3,17 | 5,27 | 8,5 | | 4,68 |
| Conductivité thermique (W/cm.K) | 1,3 | 2,5 | 0,5 | 1,5 | 4,9 |
| Diamètre maximum couramment disponible (pouces) | | | 4 | 8 | 2 |
| Qualité des substrats disponibles | | | Excellente | Excellente | Variable |
| Prix (en 2 pouces) (unité arbitraire) | | | 10 | 1 | 125 |

Le procédé selon l'invention est particulièrement avantageux lorsqu'on souhaite former une couche utile de nitrure de gallium. En effet, pour ce faire, l'art antérieur proposait plusieurs techniques présentant des inconvénients dont l'invention permet de s'affranchir.

Ainsi, selon des techniques de l'art antérieur, on utilisait un substrat de carbure de silicium monocristallin ou de saphir pour servir à la fois de support et de germe de croissance pour la couche utile. Mais lorsqu'on utilise la couche utile pour former des diodes électroluminescentes, l'utilisation d'un support massif de carbure de silicium ou de saphir ne permet pas de maîtriser de manière satisfaisante la localisation des contacts électriques, l'extraction de la lumière émise par la diode, l'utilisation d'une surface réfléchissante, etc. Ici, on peut choisir un premier support adapté à l'opération de dépôt, et de surcroît récupérable, puis un deuxième support, rapporté après enlèvement du premier, permettant de mieux maîtriser ces aspects. De plus, les substrats de carbure de silicium monocristallin, et de saphir dans une moindre mesure, sont chers et limités en diamètre, alors qu'ici, on utilise une couche germe qui peut être mince et prélevée dans un substrat éventuellement recyclable ou dans un lingot, ce qui permet d'économiser un matériau qui peut être onéreux. Par ailleurs, grâce à l'invention on peut utiliser une couche germe constituée d'un matériau que l'on obtient plus facilement dans de grands diamètres que le carbure de silicium monocristallin par exemple.

En outre, le saphir est un isolant électrique, ce qui oblige (si on le conserve sous forme d'un support massif) à réaliser des électrodes, lorsqu'elles sont nécessaires pour l'application envisagée pour la couche utile, uniquement sur la couche utile, ce qui peut donc poser des problèmes d'encombrement (par exemple si l'on doit réaliser deux contacts électriques en face avant, c'est à dire sur la surface libre de la couche utile).

L'invention permet de décorréler les propriétés souhaitées pour former un germe de croissance pour la couche utile de celles souhaitées pour le support, d'autant plus lorsqu'il est éliminé avec possibilité de recyclage, et de palier ainsi les inconvénients mentionnés ci-dessus.

Selon encore d'autres techniques de l'art antérieur, on a essayé de déposer du nitrure de gallium directement sur du nitrure de gallium massif ou encore de gallate de néodyme ou de gallate d'indium. Mais le nitrure de gallium massif est cher et ces techniques ne sont pas au point.

Selon encore d'autres techniques de l'art antérieur déjà mentionnées plus haut, on a déposé une couche utile de nitrure de gallium sur du silicium {111}. Mais si l'on utilise du silicium {111} en tant que support, c'est à dire sous forme épaisse, on observe des fissures dans la couche utile à cause d'une mauvaise adaptation en terme de dilatation thermique. L'invention, en autorisant une décorrélation des choix permet de choisir une couche germe appropriée pour la nucléation, suffisamment mince pour qu'elle soit déformée sous l'effet des contraintes thermiques et un support épais sélectionné pour son adaptation, en terme de dilatation thermique, par rapport à la couche utile que l'on fait croître sur la couche germe.

Le procédé selon l'invention comporte avantageusement les caractéristiques suivantes prises séparément ou en combinaison :
- on intercale au moins une couche de liaison entre la couche germe et le support, l'interface de collage mettant en jeu la ou lesdites couches de liaison ;
- la couche utile est constituée d'un matériau compris dans la liste comportant le nitrure de gallium, le nitrure d'aluminium et le nitrure de gallium et d'aluminium (et d'une manière générale, les nitrures semi-conducteurs à grand gap); 1
- la couche germe comprend un matériau compris dans la liste comportant le saphir, le carbure de silicium, l'oxyde de zinc, le silicium {111} ;
- la couche germe est choisie pour obtenir une structure et une orientation cristalline précise, par exemple pour obtenir du nitrure de gallium hexagonal ou cubique, ou si l'on choisit une face Si ou une face C pour déposer la couche utile sur une couche germe de carbure de silicium ;
- la couche germe est du nitrure de gallium de très bonne qualité, c'est à dire ayant moins de 10⁶ dislocations / cm², par exemple du nitrure de gallium obtenu par une technique connue de l'homme du métier sous l'expression anglo-saxonne « Epitaxial Lateral Over Growth » (dont l'acronyme est ELOG) ;
- le support comprend un matériau compris dans la liste comportant les matériaux amorphes, les matériaux polycristallins et les matériaux frittés ;
- le support comprend un matériau compris dans la liste comportant le carbure de silicium polycristallin, le carbure de silicium monocristallin, le nitrure d'aluminium polycristallin, le nitrure de gallium polycristallin, le nitrure de gallium monocristallin mais avec une forte concentration de dislocations (supérieure à 10⁷/cm²) ;
- la couche germe est de même composition chimique que le support ;
- la couche germe est prélevée d'un substrat source, en dissociant la couche germe du substrat source au niveau d'une zone pré-fragilisée ;
- la couche germe est prélevée sur un substrat source assemblé au support puis érodé par sa face libre jusqu'à obtenir une couche germe de l'épaisseur voulue (on utilisera à cette fin une technique transposée de celle permettant d'obtenir des substrats du type connu de l'homme du métier sous l'acronyme BESOI de l'expression anglo-saxonne « Bond and Etch Back Silicon on Insulator) ;
- la zone pré-fragilisée est réalisée en implantant des espèces atomiques dans le substrat source à une profondeur correspondant à l'épaisseur de la couche germe (aux étapes de finition près) ; et
- la dissociation de la couche germe et du substrat source est réalisée au moins en partie par une opération comprise dans la liste comportant un traitement thermique, une application de contraintes mécaniques et une attaque chimique, ou une combinaison d'au moins deux de ces opérations.

Ci-dessus et dans la suite de ce document, on entend par implantation atomique, tout bombardement d'espèces atomiques ou ioniques, susceptibles d'introduire ces espèces dans un matériau, avec un maximum de concentration de ces espèces dans ce matériau, ce maximum étant situé à une profondeur déterminée par rapport à la surface bombardée. Les espèces atomiques ou ioniques sont introduites dans le matériau avec une énergie distribuée autour d'un maximum. L'implantation des espèces atomiques dans le matériau peut être réalisée grâce à un implanteur par faisceau d'ions, un implanteur par immersion dans un plasma, etc. Par espèces atomiques ou ioniques, on entend un atome sous sa forme ionique, neutre ou moléculaire, ou des molécules sous une forme ionique ou neutre, ou encore une combinaison de différents atomes ou molécules sous une forme ionique ou neutre.

D'autres aspects, buts et avantages de l'invention apparaîtront à la lecture de la description détaillée qui suit, l'invention sera également mieux comprise à l'aide des dessins annexés sur lesquels :
- la figure 1 représente schématiquement des étapes d'un exemple de mise en oeuvre du procédé conforme à l'invention ;
- la figure 2 représente schématiquement des étapes d'un autre exemple de mise en oeuvre du procédé conforme à l'invention ;
- la figure 3 représente schématiquement des étapes d'encore un autre exemple de mise en oeuvre du procédé conforme à l'invention ; et
- la figure 4 représente schématiquement en perspective, un support intermédiaire avec quatre couches germe, tel qu'il peut être utilisé selon une variante du procédé selon l'invention.

Le procédé selon l'invention est décrit ci-dessous de manière détaillée à l'aide de quatre modes particuliers, mais non limitatifs, de mise en oeuvre.

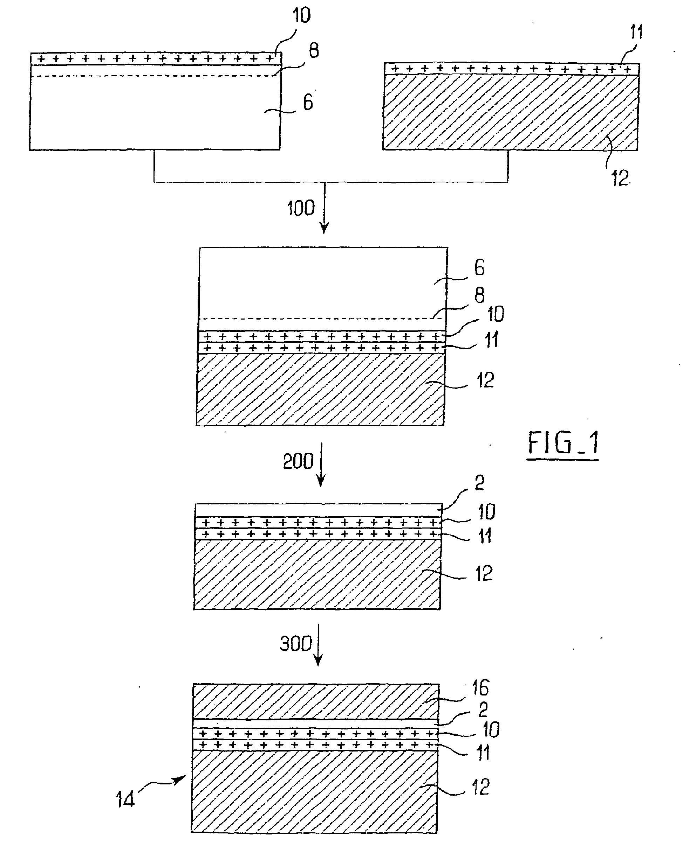

Selon le premier mode mise en oeuvre, illustré par la figure 1, on réalise un substrat final 14 comportant une couche utile 16 sur une couche germe 2 en réalisant les étapes suivantes :
- formation d'une couche de matériau amorphe pour réaliser une couche de liaison 10 sur une surface d'un substrat source 6 destinée à subir une implantation d'espèces atomiques, formation d'une couche de matériau amorphe sur une surface d'un support 12 pour réaliser une autre couche de liaison 11,
- implantation d'espèces atomiques au niveau d'une profondeur déterminée du substrat source 6 pour former une zone de fragilisation 8,
- mise en contact 100 des couches de liaison 10 et 11,
- détachement 200 d'une couche germe 2 à partir du substrat source 6 au niveau de la zone de fragilisation 8, et
- dépôt 300 d'une couche utile 16 sur la surface de la couche germe 2 correspondant à la zone de fragilisation 8.

Les étapes de formation de la couche de liaison 10 et d'implantation d'espèces atomiques peuvent être réalisées dans l'ordre indiqué ci-dessus ou dans un autre.

Des exemples d'étapes d'implantation d'espèces atomiques et de détachement 200 de la couche germe 2 sont décrites par exemple dans le brevet FR 2 681 472.

Les étapes de formation des couches de liaison 10 et 11 correspondent, par exemple, à la formation d'une couche de matériau amorphe selon l'une des méthodes connues par l'homme du métier.

Entre les étapes 200 et 300, le procédé selon l'invention comporte de manière optionnelle, des opérations de préparation de la surface de la couche germe 2 destinée à recevoir la couche utile 16. Les opérations de préparation comportent par exemple des opérations de polissage, de recuit, de recuit lissant (sous hydrogène par exemple), de recuit destiné à renforcer l'interface de collage entre les couches de liaison 10 et 11, d'oxydation sacrificielle (oxydation puis élimination de matériau oxydé), de gravure, etc.

Ce premier mode de mise en oeuvre du procédé selon l'invention est décrit de manière détaillée à l'aide de cinq exemples particuliers mais non limitatifs, que l'on décrira ci-dessous les uns après les autres, le détachement au niveau de l'interface de collage prévue dans ces exemples étant décrit à la suite de l'exemple 5.

Le tableau 2 ci-dessous regroupe des exemples de matériaux utilisables pour la mise en oeuvre du premier mode de mise en oeuvre décrit ci-dessus.

**Tableau 2**

| Couche utile 16 | Couche germe 2 (typiquement 100 nm (1000 Å) d'épaisseur) | Couches de liaison 10, 11 (typiquement 1 micron d'épaisseur) | Support 12 (typiquement 300 microns d'épaisseur) |
|---|---|---|---|
| GaN ou AlN ou AlGaN ou GalnN ou SIC ou autres | SiC mono | SiO₂ ou Si₃N₄ | SiC poly ou SiC mono ou saphir ou AIN poly ou GaN poly |
| GaN ou AIN ou AlGaN ou GaInN ou SIC ou autres | Si {111} | SiO₂ ou Si₃N₄ | SiC poly ou SiC mono ou saphir ou AIN poly ou GaN poly |
| GaN ou AIN ou AlGaN ou GalnN ou SIC ou autres | saphir | SiO₂ ou Si₃N₄ | SiC poly ou SiC mono ou saphir ou AIN poly ou GaN poly |
| GaN ou AIN ou AlGaN ou GalnN ou SIC ou autres | GaN mono | SiO₂ ou Si₃N₄ | SiC poly ou SiC mono ou saphir ou AIN poly ou GaN poly |
| GaN ou AIN ou AlGaN ou GalnN ou SIC ou autres | NdGaO₂ ou LiGaO₃ | SiO₂ ou Si₃N₄ | SiC poly ou SiC mono ou saphir ou AIN poly ou GaN poly |

Dans le tableau ci-dessus, comme dans les suivants, le terme « mono » est utilisé pour « monocristallin » et le terme « poly » est utilisé pour « polycristallin ».

### EXEMPLE 1 :

Selon l'exemple correspondant à la première ligne du tableau 2, on réalise une couche utile 16 de nitrure de gallium sur une couche germe 2 constituée de carbure de silicium monocristallin, elle-même sur un support 12 de carbure de silicium polycristallin, des couches de liaison 10 et 11 d'oxyde de silicium étant intercalées entre le support 12 et la couche germe 2.

La couche germe 2 fait par exemple 100nm (1000 Å) d'épaisseur. Le support 12 fait par exemple 300 microns d'épaisseur.

La structure constituée de l'empilement de la couche germe 2 de carbure de silicium monocristallin, des deux couches de liaison 10 et 11 d'oxyde de silicium et du support 12 de carbure de silicium polycristallin est réalisée par un procédé de transfert de couches connu de l'homme du métier (par exemple, voir une mise en application d'un procédé Smart-Cut^{®} dans le brevet FR 2 681 472).

La couche utile 16 peut être réalisée par dépôt chimique en phase vapeur (aussi connu de l'homme du métier sous l'acronyme CVD de l'expression anglo-saxonne « Chemical Vapor Deposition »), par dépôt chimique en phase vapeur à haute température (aussi connue de l'homme du métier sous l'acronyme HTCVD de l'expression anglo-saxonne « High Temperature Chemical Vapor Deposition »), par MOCVD, par MBE, voire par épitaxie en phase vapeur d'hydrure (aussi connue par l'homme du métier sous l'acronyme HVPE de l'expression anglo-saxonne « Hydride Vapor Phase Epitaxy », voir par exemple le document « GaN bulk substrates for GaN based LEDs and LDs », O. Oda *et al*., Phys. Stat. Sol. (a), N°180, p. 51 (2000)) ou d'autres techniques équivalentes.

L'utilisation de l'oxyde de silicium, pour la couche de liaison 10, facilite la réalisation du prélèvement de la couche germe 2 sur le substrat source 6. En effet, le dépôt planarisé de l'oxyde de silicium permet de gommer les irrégularités de surface et de réaliser des étapes de polissage, de planarisation, de nettoyage, de préparation chimique et de collage de cet oxyde de silicium sur l'oxyde de silicium de la couche de liaison 11 formée sur le support 12, par des techniques connues et aisées à mettre en oeuvre. L'ensemble des couches de liaison 10 et 11 fait par exemple un micron d'épaisseur.

### EXEMPLE 2 :

Selon cet exemple (deuxième ligne du tableau ci-dessus), on réalise une structure équivalente à celle de l'exemple 1, dans laquelle on remplace la couche germe 2 de carbure de silicium par une couche germe 2 de silicium {111}.

De préférence, l'épaisseur du silicium {111} est limitée à une épaisseur inférieure à 300nm (3000 Å), afin qu'elle puisse s'adapter sans fissurer, à la dilatation thermique susceptible de se produire lors des différentes opérations mentionnées ci-dessus.

### EXEMPLE 3 :

Selon cet exemple (troisième ligne du tableau ci-dessus), on réalise une structure équivalente à celle des exemples 1 et 2, dans laquelle la couche germe 2 est composée de saphir.

Le saphir est aussi un matériau connu pour permettre une bonne épitaxie du nitrure de gallium.

### EXEMPLE 4 :

Selon cet exemple (quatrième ligne du tableau ci-dessus), on réalise une structure équivalente à celle des exemples 1 à 3, dans laquelle la couche germe 2 est composée de nitrure de gallium monocristallin.

### EXEMPLE 5 :

Selon cet exemple (cinquième ligne du tableau ci-dessus), on réalise une structure équivalente à celle des exemples 1 à 4, dans laquelle la couche germe 2 est composée de gallate de néodyme ou de gallate de lithium.

De nombreuses variantes des exemples précédents peuvent être envisagées.

Ainsi, l'oxyde de silicium de l'une des couches de liaison 10 et 11, ou l'oxyde de silicium des deux couches de liaison 10 et 11 peut être remplacé par un autre matériau, par exemple le nitrure de silicium (Si₃N₄). Ce dernier permet de supporter des températures plus élevées que l'oxyde de silicium. Cet avantage est particulièrement intéressant dans le cadre de l'optimisation du dépôt de la couche utile 16 en vue de la formation d'une couche monocristalline de bonne qualité ou encore lorsque l'on souhaite augmenter la vitesse du dépôt. Le nitrure de silicium présente également l'avantage de limiter voire d'éviter la diffusion du gallium dans le support 12.

Selon encore une autre variante de ce premier mode de mise en oeuvre du procédé selon l'invention, la couche utile 16 de nitrure de gallium est remplacée par une couche utile 16 de nitrure d'aluminium, de carbure de silicium, d'un alliage d'aluminium et de gallium, d'un alliage de gallium et d'indium ou d'autres composés. La couche utile 16 de nitrure de gallium peut également être remplacée par une structure multicouche empilant des couches de type nitrure de gallium, nitrure d'aluminium, de nitrure de gallium et d'indium etc., éventuellement avec des dopages de natures différentes, etc.

Selon encore d'autres variantes, le support 12 de carbure de silicium polycristallin est remplacé par du carbure de silicium monocristallin (notamment dans le cas où le support 12 peut être recyclé comme indiqué ci-dessous), du saphir, du nitrure d'aluminium polycristallin ou du nitrure de gallium polycristallin.

On élimine, après croissance de la couche utile 16, le support 12, après avoir éventuellement, si c'est nécessaire pour des questions de rigidité, renforcé le tout par un autre support soit par collage direct, soit par formation de cet autre support par dépôt sur la couche utile, etc.

Le support 12 doit alors non seulement pouvoir supporter les conditions de croissance de la couche utile 16, mais gagne à pouvoir être supprimé. La voie choisie pour retirer le support intermédiaire 12 peut conditionner le choix du matériau constitutif de celui-ci. En effet, si l'on souhaitait le sacrifier par gravure ou par enlèvement mécanique ou chimique, les étapes de gravure et d'enlèvement, ainsi que le support intermédiaire 12 lui-même, devraient être aussi peu coûteux que possible. Selon ce critère, on choisirait un support 12 en nitrure d'aluminium polycristallin.

On peut réaliser tout ou partie de composants sur la couche utile 16, avant ou après élimination du support 12.

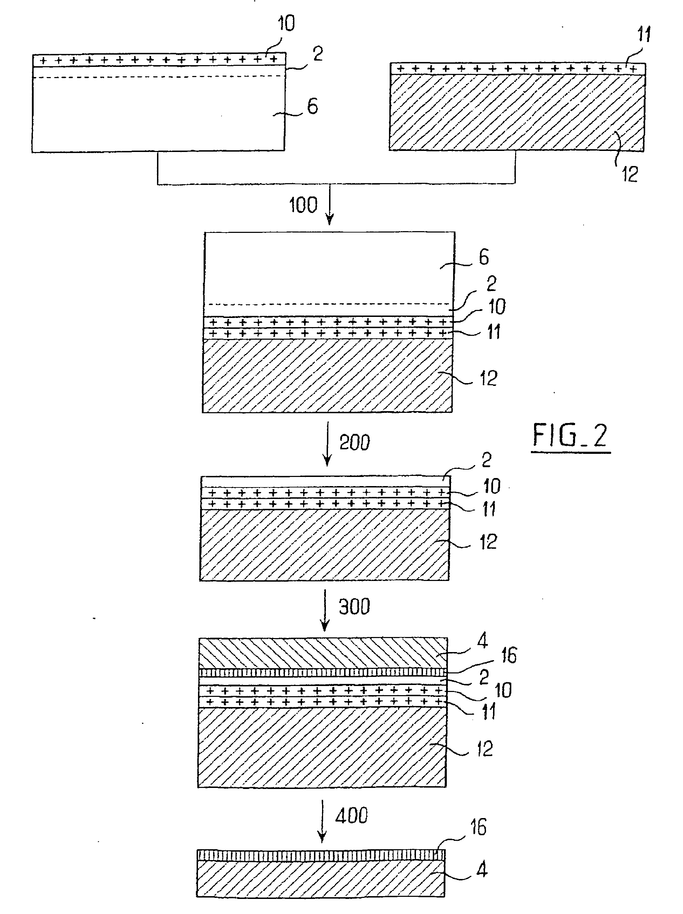

Selon le deuxième mode de mise en oeuvre du procédé selon l'invention, illustré par la figure 2, on réalise, conformément au premier exemple de mise en oeuvre du procédé selon l'invention décrit ci-dessus, une structure comportant une couche utile 16 sur une couche germe 2, elle-même sur un support 12, avec des couches de liaison 10 et 11 intercalées entre la couche germe 2 et le support 12. Puis conformément au présent mode de mise en oeuvre, on dépose une couche épaisse 4, sur la surface libre de la couche utile 16 et on élimine le support 12, et éventuellement la couche germe 2. La couche épaisse 4 sert alors en particulier à former un support à la couche utile 16, après élimination du support 12.

Le tableau 3 ci-dessous regroupe des exemples de matériaux utilisables dans le cadre de ce deuxième mode de mise en oeuvre du procédé selon l'invention.

**Tableau 3**

| Couche utile 16 | Couche germe 2 | Couches de liaison 10, 11 | Support 12 | Couche épaisse 4 |
|---|---|---|---|---|
| GaN ou AIN ou AlGaN ou GalnN ou SIC ou autres | Si {111} ou SiC mono ou GaN ou saphir ou NdGaO₂ ou LiGaO₃ | SiO₂ ou Si₃N₄ | SiC poly ou AIN poly ou saphir ou SiC mono ou GaN poly | diamant ou SiC poly ou GaN ou AIN ou nitrure de bore ou métal (cuivre) |

### EXEMPLE 6 :

Selon cet exemple, on réalise une couche germe 2 de silicium {111} monocristallin sur un support 12 de carbure de silicium polycristallin avec des couches de liaison 10 et 11 d'oxyde de silicium, entre les deux. Puis on dépose une couche utile 16 de nitrure de gallium monocristallin par MOCVD, et une couche épaisse 4 de diamant, sur la face libre du nitrure de gallium monocristallin de la couche utile 16.

La structure ainsi obtenue subit ensuite un traitement apte à produire un détachement de l'ensemble constitué de la couche utile 16, de l'ensemble constitué du support 12 et de la couche germe 2. Ce traitement comprend l'utilisation de contraintes mécaniques, thermiques, électrostatiques, etc., pour provoquer un détachement de deux parties situées de part et d'autre de l'interface de collage.

Cet exemple présente l'avantage que l'on peut utiliser un support 12 dont la surface destinée à recevoir la couche germe 2 est mal finie, mais qu'après avoir formé la couche utile 16 de GaN grâce à la couche germe 2 de silicium {111}, on peut réaliser un support final (la couche épaisse 4) pour la couche utile 16 ayant des propriétés adaptées à l'utilisation de cette couche utile 16 (ici, avec le diamant, de bonnes propriétés de conduction thermique et de bonnes propriétés isolantes électriques, pour des applications en hyperfréquences par exemple), ainsi qu'une bonne qualité d'interface entre la couche épaisse 4 et la couche utile 16 pour une conduction thermique accrue, par exemple.

Cet exemple peut comporter de nombreuses variantes.

Ainsi, on peut remplacer la couche germe 2 de silicium {111}, par du carbure de silicium monocristallin, du saphir, du gallate de néodyme ou du gallate de lithium ; les couches de liaison 10 et 11 d'oxyde de silicium peuvent être remplacées par du nitrure de silicium ; le support 12 de carbure de silicium polycristallin, peut être remplacé par du carbure de silicium monocristallin ou du saphir ; et la couche épaisse 4 de diamant peut être remplacée pour du carbure de silicium polycristallin, du nitrure de gallium polycristallin (déposé par HVPE par exemple), du nitrure de bore ou un métal (déposé en couche épaisse par électrolyse par exemple), tel que du cuivre, etc.

On notera que les propriétés en épaisseur de la couche épaisse 4 peuvent être importantes par exemple, lorsque l'on souhaite prendre un contact électrique en face arrière du substrat final 14 ou lorsque l'évacuation de la chaleur générée par les composants réalisés sur la couche utile 16 est déterminante ou encore lorsque l'on souhaite mieux extraire et maîtriser la lumière émise par une diode ou un laser réalisé sur la couche utile 16. On comprend alors que le choix des propriétés de la couche épaisse 4 offre un degré de liberté dans les procédés de fabrication de substrats particulièrement intéressant pour la réalisation de substrats pour l'optique, l'électronique, l'opto-électronique, etc. On peut encore rajouter un degré de liberté dans les procédés de fabrication de substrats, en prévoyant des étapes de préparation (connues en elles-mêmes de l'homme du métier) telles que la couche épaisse 4 puisse être démontée de la couche utile 16, par la suite.

De même, ces variantes sont transposables aux cas où l'on forme une couche utile 16 de nitrure d'aluminium, de carbure de silicium, d'un alliage d'aluminium et de gallium, ou d'autres composés, à la place de la couche utile 16 de nitrure de gallium, comme cela a été décrit ci-dessus. La couche utile 16 de nitrure de gallium peut également être une structure multicouche empilant des couches de type nitrure de gallium, nitrure d'aluminium, etc., éventuellement avec des dopages de natures différentes, etc.

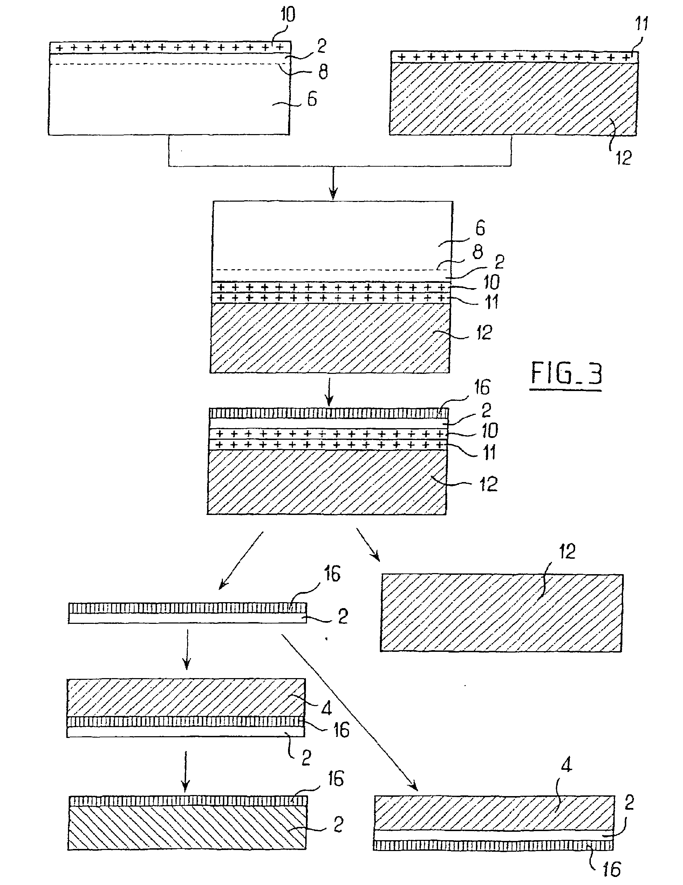

Selon le troisième exemple de mode de mise en oeuvre du procédé selon l'invention, illustré par la figure 3, on réalise une structure dans laquelle la couche épaisse 4 est, contrairement à ce qui a été décrit en relation avec le deuxième mode de mise en oeuvre du procédé selon l'invention, déposée après séparation de la couche utile 16 et du support 2. La couche épaisse 4 est alors déposée soit du côté de la couche germe 2, sur cette couche germe 2 ou sur la face de la couche utile 16 correspondante, si la couche germe 2 a été retirée en même temps que le support 12 ou après ce dernier, soit du côté de la face libre de la couche utile 16.

Le troisième mode de mise en oeuvre du procédé selon l'invention est décrit ci-dessous à l'aide de trois exemples.

Les matériaux utilisés dans le cadre de ces trois exemples sont regroupés dans le tableau 4 et correspondent à ceux du tableau 3.

**Tableau 4**

| Couche utile 16 | Couche germe 2 | Couches de liaison 10,11 | Support 12 | Couche épaisse 4 |
|---|---|---|---|---|
| GaN ou AIN ou AlGaN ou GalnN ou SIC | SiC mono ou Si {111} ou Saphir ou GaN ou NdGaO₂ ou LiGaO₃ | SiO₂ ou Si₃N₄ | SiC mono ou SiC poly ou AIN poly ou saphir ou GaN poly | AIN ou GaN ou SiC poly ou diamant ou nitrure de bore ou métal |
| GaN ou AlN ou AlGaN ou GalnN ou SIC | SiC mono ou Si {111} ou Saphir + Gravure GaN ou NdGaO₂ ou LiGaO₃ | SiO₂ ou Si₃N₄ | SiC mono ou SiC poly ou AlN poly ou saphir ou GaN poly | AlN ou GaN ou SiC poly ou diamant ou nitrure de bore ou métal |
| + Gravure d'une partie du GaN ou du AIN ou du AlGaN ou du GalnN ou du SIC | SiC mono ou Si {111} ou Saphir + Gravure GaN ou NdGaO₂ ou LiGaO₃ | SiO₂ ou Si₃N₄ | SiC mono ou SiC poly ou AIN poly ou saphir ou GaN poly | AIN ou GaN ou SiC poly ou diamant ou nitrure de bore ou métal |

### EXEMPLE 7 :

Selon cet exemple (première ligne du tableau 4), on réalise une structure comprenant une couche germe 2 de carbure de silicium monocristallin sur un support 12 de carbure de silicium monocristallin, avec des couches de liaison 10 et 11 d'oxyde de silicium entre les deux, de la manière décrite ci-dessus pour l'exemple 1. On réalise ensuite, sur la surface libre de la couche germe 2 de carbure de silicium, une couche utile 16 de nitrure de gallium monocristallin par MOCVD. La structure ainsi obtenue subit ensuite un traitement apte à séparer la structure constituée de la couche germe 2 et de la couche utile 16, du support 12. On obtient ainsi d'une part une structure constituée d'une couche utile 16 de nitrure de gallium, recouverte d'une couche germe 2 de carbure de silicium monocristallin et d'autre part le support 12 prêt à être recyclé. Une couche épaisse 4 de carbure de silicium polycristallin est alors déposée par dépôt chimique en phase vapeur sur la couche la couche germe 2.

Le support 12 en carbure de silicium monocristallin est relativement cher, mais il est, dans le présent exemple, recyclé lors de la mise en oeuvre de reproductions ultérieures du procédé selon l'invention.

### EXEMPLE 8 :

Selon un autre exemple (deuxième ligne du tableau 4) de ce troisième mode de mise en oeuvre du procédé selon l'invention, on réalise la structure de l'exemple 8, mais la couche germe 2 de carbure de silicium monocristallin est retirée, par exemple par une gravure dans un plasma, avant formation de la couche épaisse 4 de carbure de silicium polycristallin.

### EXEMPLE 9 :

Selon encore un autre exemple de ce troisième mode de mise en oeuvre du procédé selon l'invention (troisième ligne du tableau 4), on réalise une structure telle que celle de l'exemple 9, à la différence que l'on retire non seulement la couche germe 2 de carbure de silicium monocristallin mais en plus une partie de la couche utile 16 de nitrure de gallium, pour conserver une couche utile 16 présentant le moins de défauts possible.

On peut noter que la couche germe 2 de carbure de silicium monocristallin ou la couche utile 16 de nitrure de gallium monocristallin peut subir quelques étapes technologiques supplémentaires avant d'être soumise au dépôt de la couche épaisse 4, ces étapes visant à réaliser des composants électroniques, en totalité ou en partie, ou faire l'objet de dépôts uniformes de films additionnels de nature épitaxiale ou non.

Il faut noter également que la polarité de la couche germe 2 de carbure de silicium monocristallin (face Si ou face C) et celle de la couche utile 16 de nitrure de gallium peut être déterminée par le choix de la polarité du substrat source 6 initial. Eventuellement, le procédé selon l'invention comprend au moins un double transfert permettant de changer deux fois la polarité.

De même, ces exemples sont transposables aux cas où l'on forme conformément à l'invention, une couche utile 16 de nitrure d'aluminium, de carbure de silicium, d'un alliage d'aluminium et de gallium, d'un alliage d'indium et de gallium, ou d'autres composés, à la place de la couche utile 16 de nitrure de gallium, comme cela a été décrit ci-dessus. La couche utile 16 de nitrure de gallium peut également être une structure multicouche empilant des couches de type nitrure de gallium, nitrure d'aluminium, etc., éventuellement avec des dopages de natures différentes, etc.

La couche germe 2 peut être constituée de silicium {111} ou de saphir ou de gallate de néodyme ou de gallate de d'indium, etc. plutôt que de carbure de silicium monocristallin.

Ce support 12 peut être constitué de carbure de silicium polycristallin ou de nitrure de silicium polycristallin ou de nitrure d'aluminium polycristallin ou de saphir ou de nitrure de gallium polycristallin, plutôt que de carbure de silicium monocristallin. La couche épaisse 4 peut être constituée de nitrure d'aluminium polycristallin ou de diamant ou de nitrure de bore, plutôt que de carbure de silicium polycristallin.

Selon le quatrième mode de mise en oeuvre du procédé selon l'invention, on réalise une structure telle que celles des exemples ci-dessus, mais dans laquelle on ne réalise pas de couches intermédiaires 10 et 11. A titre d'exemple, on prélève une couche germe 2 sur un substrat source 6 de silicium {111}, que l'on assemble avec un support 12 de carbure de silicium polycristallin par collage direct (par exemple comme indiqué dans les modes de mise en oeuvre précédents). Puis on dépose, par l'une des techniques déjà mentionnées une couche utile 16 de nitrure de gallium sur la couche germe 2.

De nombreuses autres variantes aux modes de mise en oeuvre décrits ci-dessus peuvent encore être envisagées sans sortir du cadre de l'invention.

On pourra par exemple combiner ensemble des opérations décrites dans des exemples différents de modes de mise en oeuvre du procédé selon l'invention.

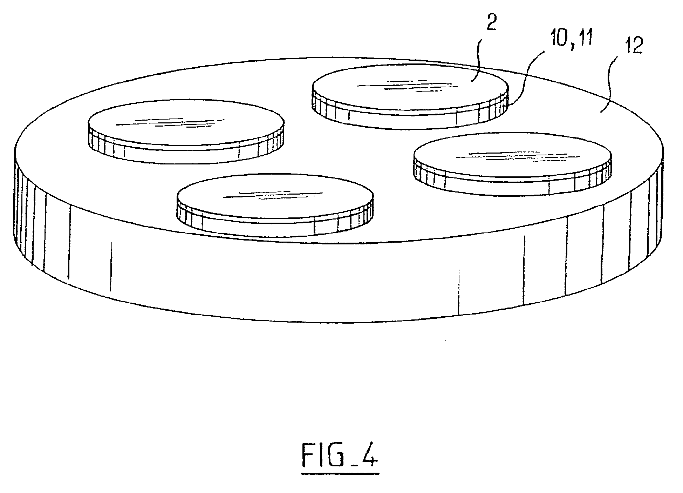

Comme représenté sur la figure 4, une variante consiste à traiter, les couches germes 2 obtenues avant dépôt de la couche utile 16, par lots. Dans ce cas, ces couches germes 2 sont fixées sur un support 12 unique de grande dimension.

La forme de ce support 12 unique peut être quelconque (circulaire, rectangulaire, etc.).

Dans ce cas, les couches germes 2 peuvent être identiques ou différentes. Chacune de ces couches germes 2 peut faire l'objet d'une opération séparée de détachement de la couche germe du support 12. Le support 12 unique est par exemple une plaque de carbure de silicium polycristallin recouverte d'un oxyde de silicium.

Avantageusement, un substrat raidisseur est collé sur la couche utile 16 des différents ensembles, avant l'opération ayant pour but de détacher les ensembles couche utile 16 sur couche germe 2, du support 12.

Chaque support 12 unique est recyclé.

Selon une autre variante du procédé selon l'invention, on optimise les paramètres de dépôt de la couche épaisse 4 afin de réaliser une couche épaisse 4 monocristalline.

Même si la qualité d'une telle couche épaisse 4 monocristalline n'est pas optimale, elle peut s'avérer suffisante pour de nombreuse applications, pour lesquelles une très bonne qualité cristalline n'est requise que pour la couche utile 16.

Le procédé selon l'invention est particulièrement intéressant lorsque la croissance de lingots n'existe pas (cas du nitrure de gallium) ou lorsqu'elle est onéreuse (cas du carbure de silicium).

Selon d'autres variantes, ce qui a été exposé ci-dessus est transposé à la croissance d'une couche utile d'autres matériaux semi-conducteurs, tels que le phosphure d'indium, l'arséniure de gallium, le germanium, le silicium-germanium, etc., ou encore d'autres matériaux tels que le niobate de lithium.

Selon encore d'autres variantes, on n'utilisera pas de couches de liaison 10 ou 11, ou on n'en utilisera qu'une (sur le support 12 ou sur la couche germe 2).

Selon encore d'autres variantes, on réalise une couche intermédiaire, par exemple isolante, entre la couche utile 16 et / ou la couche germe 2 (si elle est conservée) et le support 12 ou la couche épaisse 4, pour former un substrat de semi-conducteur sur isolant. Cette couche intermédiaire est par exemple en diamant, en oxyde fin 50nm (500Å), etc.

## Revendications

1. Procédé de fabrication de substrats, notamment pour l'optique, l'électronique ou l'opto-électronique, comprenant les étapes suivantes :
- report d'une couche germe (2) sur un support (12) par adhésion moléculaire au niveau d'une interface de collage,
- épitaxie d'une couche utile (16) sur la couche germe,
**caractérisé en ce qu'**il comprend également les étapes suivantes :
- collage direct d'un substrat raidisseur sur ladite couche utile (16),
- retrait du support (12),
ledit support (12) étant constitué d'un matériau dont le coefficient de dilatation thermique est 0,7 à 3 fois celui de la couche utile (16), et la couche germe (2) étant apte à s'adapter aux dilatations thermiques du support (12) et de la couche utile (16).

2. Procédé selon la revendication 1, **caractérisé par le fait que** la couche de germe (2) possède des paramètres cristallins tels qu'on réalise une épitaxie de la couche utile (16) sur la couche germe (2) avec une concentration de dislocations dans la couche utile (16) inférieure à 10⁷/cm².

3. Procédé selon la revendication 1 ou 2, **caractérisé par le fait que** le support (12) est retiré par gravure.

4. Procédé selon l'une des revendications précédentes, **caractérisé par le fait que** le support (12) est retiré de façon mécanique ou chimique.

5. Procédé selon l'une des revendications précédentes, **caractérisé par le fait que** l'on intercale au moins une couche de liaison (10, 11) entre la couche germe (2) et le support (12), l'interface de collage mettant en jeu la ou lesdites couches de liaison.

6. Procédé selon l'une des revendications précédentes, **caractérisé en ce que** la couche utile (16) est constituée de nitrures semi-conducteurs.

7. Procédé selon la revendication 6, **caractérisé par le fait que** la couche utile (16) est constituée d'un matériau compris dans la liste comprenant le nitrure de gallium, le nitrure d'aluminium et le nitrure de gallium et d'aluminium.

8. Procédé selon l'une des revendications précédentes, **caractérisé par le fait que** la couche germe (2) comprend un matériau compris dans la liste comprenant le saphir, le carbure de silicium, l'oxyde de zinc, le silicium {111}, le nitrure de gallium, le gallate de néodyme et le gallate de lithium.

9. Procédé selon l'une des revendications précédentes, **caractérisé par le fait que** le support (12) comprend un matériau compris dans la liste comportant les matériaux amorphes, les matériaux polycristallins et les matériaux frittés.

10. Procédé selon la revendication 9, **caractérisé par le fait que** le support (12) comprend un matériau compris dans la liste comportant le carbure de silicium polycristallin, le carbure de silicium monocristallin, le nitrure d'aluminium polycristallin, le nitrure de gallium polycristallin et le saphir.

11. Procédé selon l'une des revendications précédentes, **caractérisé par le fait que** la couche germe (2) est de même composition chimique que le support (12).

12. Procédé selon l'une des revendications précédentes, **caractérisé par le fait que** la couche germe (2) est prélevée d'un substrat source (6), en dissociant la couche germe (2) du substrat source (6), au niveau d'une zone pré-fragilisée (8).

13. Procédé selon revendication 12, **caractérisé par le fait que** la zone pré-fragilisée (8) est réalisée en implantant des espèces atomiques dans le substrat source (6) à une profondeur correspondant à l'épaisseur de la couche germe (2).

14. Procédé selon la revendication 12 ou 13, **caractérisé par le fait que** la dissociation de la couche germe (2) et du substrat source (6) est réalisée au moins en partie par une opération comprise dans la liste comportant : un traitement thermique, une application de contraintes mécaniques et une attaque chimique, ou une combinaison d'au moins deux de ces opérations.

15. Procédé selon l'une des revendications précédentes, **caractérisé par le fait que** la couche utile (16) est déposée sur une épaisseur inférieure à 10 microns, de préférence inférieure à 5 microns.

## Claims

1. A Method of fabricating substrates, in particular for optics, electronics, or optoelectronics, the method comprising the following steps:
. transferring a seed layer (2) onto a support (12) by molecular adhesion at a bonding interface;
. growing a working layer (16) epitaxially on the seed layer;
**characterized in that** it also comprises the following steps:
. directly bonding a strengthening support on said working layer (16);
. removing the support (12),
said support (12) being constituted by a material whose coefficient of thermal expansion is 0.7 to 3 times the coefficient of the working layer (16), and the seed layer (2) being suitable for accommodating the thermal expansion of the support (12) and of the working layer (16).

2. Method according to claim 1, **characterized by** the fact that the seed layer (2) possesses crystal lattice parameters such that the working layer (16) is grown epitaxially on the seed layer (2),with a dislocation concentration in the working layer (16) of less than 10⁷/cm².

3. Method according to claim 1 or 2, **characterized by** the fact that the support (12) is removed by etching.

4. Method according to any of the preceding claims, **characterized by** the fact that the support (12) is removed by mechanical or chemical removal.

5. Method according to any of the preceding claims, **characterized by** the fact that at least one bonding layer (10, 11) is interposed between the seed layer (2) and the support (12), the bonding interface involving the said bonding layer(s).

6. Method according to any of the preceding claims, **characterized in that** the working layer (16) is made of semi-conductive nitrides.

7. Method according to claim 6, **characterized by** the fact that the working layer (16) is made of a material taken from the list comprising gallium nitride, aluminium nitride and aluminium and gallium nitride.

8. Method according to any of the preceding claims, **characterized by** the fact that the seed layer (2) comprises a material taken from the list comprising sapphire, silicon carbide, zinc oxide, {111} silicon, gallium nitride, neodymium gallate and lithium gallate.

9. Method according to any of the preceding claims, **characterized by** the fact that the support (12) comprises a material taken from the list comprising amorphous materials, polycrystalline materials and sintered materials.

10. Method according to claim 9, **characterized by** the fact that the support (12) comprises a material taken from the list comprising polycrystalline silicon carbide, monocrystalline silicon carbide, polycrystalline aluminum nitride, polycrystalline gallium nitride and sapphire.

11. Method according to any of the preceding claims, **characterized by** the fact that the seed layer (2) has the same chemical composition as the support (12).

12. Method according to any of the preceding claims, **characterized by** the fact that the seed layer (2) is taken from a source substrate (6) by detaching the seed layer (2) from the source substrate (6), via a pre-weakened zone (8).

13. Method according to claim 12, **characterized by** the fact that the pre-weakened zone (8) is made by implanting atomic species in the source substrate (6) at a depth corresponding to the thickness of the seed layer (2).

14. Method according either of claims 12 or 13, **characterized by** the fact that the seed layer (2) is detached from the source substrate (6) at least partially by an operation taken from the list comprising: heat treatment, applying mechanical stresses and chemical etching, or a combination of at least two of these operations.

15. Method according to any of the preceding claims, **characterized by** the fact that the working layer (16) is deposited with a thickness of less than 10 microns, and preferably less than 5 microns.

## Patentansprüche

1. Verfahren zur Herstellung von Substraten, insbesondere für die Optik, die Elektronik oder die Optoelektronik, welches die folgenden Schritte umfasst:
- Übertragen einer Keimschicht (2) auf einen Träger (12) durch molekulare Adhäsion auf der Ebene einer Klebungszwischenschicht,
- Epitaxie einer Nutzschicht (16) auf der Keimschicht,
**dadurch gekennzeichnet, dass** es gleichfalls die folgenden Schritte umfasst:
- direktes Aufkleben eines versteifenden Substrats auf die Nutzschicht (16),
- Entfernen des Trägers (12),
wobei der Träger (12) aus einem Material besteht, dessen Wärmeausdehnungskoeffizient das 0,7- bis 3-fache von jenem der Nutzschicht (16) beträgt, und wobei die Keimschicht (2) in der Lage ist, sich an die Wärmeausdehnungen des Trägers (12) und der Nutzschicht (16) anzupassen.

2. Verfahren nach Anspruch 1, **dadurch gekennzeichnet, dass** die Keimschicht (2) derartige Kristallparameter aufweist, dass eine Epitaxie der Nutzschicht (16) auf der Keimschicht (2) mit einer Konzentration an Dislokationen in der Nutzschicht (16) unter 10⁷/cm² realisiert wird.

3. Verfahren nach Anspruch 1 oder 2, **dadurch gekennzeichnet, dass** der Träger (12) durch Gravieren entfernt wird.

4. Verfahren nach einem der vorangegangenen Ansprüche, **dadurch gekennzeichnet, dass** der Träger (12) auf mechanische oder chemische Weise entfernt wird.

5. Verfahren nach einem der vorangegangenen Ansprüche, **dadurch gekennzeichnet, dass** man mindestens eine Verbindungsschicht (10, 11) zwischen der Keimschicht (2) und dem Träger (12) angeordnet vorsieht, wobei die Klebungszwischenschicht die Verbindungsschicht oder Verbindungsschichten einsetzt.

6. Verfahren nach einem der vorangegangenen Ansprüche, **dadurch gekennzeichnet, dass** die Nutzschicht (16) aus halbleitenden Nitriden besteht.

7. Verfahren nach Anspruch 6, **dadurch gekennzeichnet, dass** die Nutzschicht (16) aus einem Material besteht, das in der Galliumnitrid, Aluminiumnitrid und Galliumaluminiumnitrid umfassenden Liste enthalten ist.

8. Verfahren nach einem der vorangegangenen Ansprüche, **dadurch gekennzeichnet, dass** die Keimschicht (2) ein Material umfasst, welches in der Saphir, Siliciumcarbid, Zinkoxid, Silicium {1,1,1}, Galliumnitrid, Neodymgallat und Lithiumgallat umfassenden Liste enthalten ist.

9. Verfahren nach einem der vorangegangenen Ansprüche, **dadurch gekennzeichnet, dass** der Träger (12) ein Material umfasst, welches in der die amorphen Materialien, die polykristallinen Materialien und die gesinterten Materialien umfassenden Liste enthalten ist.

10. Verfahren nach Anspruch 9, **dadurch gekennzeichnet, dass** der Träger (12) ein Material umfasst, das in der polykristallines Siliciumcarbid, monokristallines Siliciumcarbid, polykristallines Aluminiumnitrid, polykristallines Galliumnitrid und Saphir umfassenden Liste enthalten ist.

11. Verfahren nach einem der vorangegangenen Ansprüche, **dadurch gekennzeichnet, dass** die Keimschicht (2) die gleiche chemische Zusammensetzung wie der Träger (12) aufweist.

12. Verfahren nach einem der vorangegangenen Ansprüche, **dadurch gekennzeichnet, dass** die Keimschicht (2) von einem Ursprungssubstrat (6) abgenommen wird, indem die Keimschicht (2) von dem Ursprungssubstrat (6) auf der Ebene einer vorab fragil gemachten Zone (8) getrennt wird.

13. Verfahren nach Anspruch 12, **dadurch gekennzeichnet, dass** die vorab fragil gemachte Zone (8) realisiert wird, indem Atomspezies in das Ursprungssubstrat (6) in einer Tiefe, welche der Dicke der Keimschicht (2) entspricht, implantiert werden.

14. Verfahren nach Anspruch 12 oder 13, **dadurch gekennzeichnet, dass** die Trennung der Keimschicht (2) und des Ursprungssubstrats (6) wenigstens zum Teil durch einen Arbeitsvorgang, der in der Liste, umfassend: eine Wärmebehandlung, eine Anwendung von mechanischen Beanspruchungen und einen chemischen Angriff, enthalten ist, oder eine Kombination von wenigstens zwei von diesen Arbeitsvorgängen realisiert wird.

15. Verfahren nach einem der vorangegangenen Ansprüche, **dadurch gekennzeichnet, dass** die Nutzschicht (16) in einer Dicke unter 10 µm, vorzugsweise unter 5 µm abgeschieden wird.
